# EUROPEAN PATENT APPLICATION

(11) **EP 3 159 392 A1**
(43) Date of publication of application: **26.04.2017**
(21) Application number: 15810069.3
(22) Date of filing: 18.06.2015
(51) Int. Cl.: C09K 11/08, C09K 11/59, H01L 33/50

(54) **METHOD FOR MANUFACTURING SURFACE-TREATED PHOSPHOR, SURFACE-TREATED PHOSPHOR, WAVELENGTH CONVERSION MEMBER, AND LIGHT EMISSION DEVICE**

(30) Priority: 18.06.2014 JP 2014125372
(71) Applicant: Panasonic Intellectual Property Management Co., Ltd., Osaka-shi, Osaka 540-6207 (JP)
(72) Inventor: SHIBAMOTO, Shinji, Osaka-shi Osaka 540-6207 (JP); OSHIO, Shozo, Osaka-shi Osaka 540-6207 (JP); YAMAZAKI, Keiichi, Osaka-shi Osaka 540-6207 (JP); MIYAZAKI, Emi, Osaka-shi Osaka 540-6207 (JP); WEN, Di, Osaka-shi Osaka 540-6207 (JP)
(74) Representative: Müller-Boré & Partner Patentanwälte PartG mbB
(86) International application number: PCT/JP2015/003049
(87) International publication number: WO 2015/194180

(57) **Abstract**

A method of manufacturing a surface-treated phosphor (11) in which the surface of an alkaline-earth silicate phosphor (12) containing a silicate of alkaline-earth metal is covered with a surface treatment layer (13), the method comprising:
surface treatment which brings the alkaline-earth silicate phosphor (12) into contact with the surface treatment substance (23) molten or pyrolyzed to form the surface treatment layer (13) on the surface of the alkaline-earth silicate phosphor (12) wherein
the surface treatment substance (23) is at least one selected from a group consisting of a sulfate, a phosphate, a carbonate, a borate, a boric acid, a titanate, and a fluoride.

## Description

### TECHNICAL FIELD

The disclosure relates to a method of manufacturing a surface-treated phosphor in which the surface of an alkaline-earth silicate phosphor is covered with a surface treatment layer, a surface-treated phosphor obtained by the method, a wavelength conversion member including the same, and a light emission device including the same.

### BACKGROUND ART

Alkaline-earth silicate phosphors such as (Sr,Ba,Ca)₂SO₄:Eu²⁺, for example, have attracted attention as a phosphor for white LEDs because light with various wavelengths is easily obtained with the alkaline-earth silicate phosphors by controlling the composition thereof and the alkaline-earth silicate phosphors have high luminous efficiency.

However, alkaline-earth silicate phosphors generally have low moisture resistance. Specifically, in the presence of water or moisture in the air, alkaline-earth metal reacts with water to produce hydroxides in the surface of the alkaline-earth silicate phosphor. The production of hydroxides deteriorates the alkaline-earth silicate phosphor, reducing the luminous efficiency. Some techniques have been proposed to form a surface treatment layer resistant to moisture on the surface of alkaline-earth silicate phosphor.

For example, a manufacturing method is proposed which brings an alkaline-earth silicate phosphor into contact with a surface treatment solution containing a water-soluble compound such as a sulfate to form a surface treatment layer on the surface of the alkaline-earth silicate phosphor (Patent Literature 1, for example).

### CITATION LIST

### PATENT LITERATURE

Patent Literature 1: Japanese Unexamined Patent Application Publication No. 2013-40236

### SUMMARY OF INVENTION

A method of manufacturing a surface-treated phosphor of the disclosure is a method of manufacturing a surface-treated phosphor in which the surface of an alkaline-earth silicate phosphor containing a silicate of alkali-earth metal is covered with a surface treatment layer. The method of manufacturing a surface-treated phosphor includes surface treatment that brings the alkaline-earth silicate phosphor into contact with a molten or pyrolyzed surface treatment substance to form a surface treatment layer on the surface of the alkaline-earth silicate phosphor. The surface treatment substance is at least one selected from a group consisting of a sulfate, a phosphate, a carbonate, a borate, a boric acid, a titanate, and a fluoride.

With the aforementioned configuration, it is possible to manufacture a surface-treated phosphor with high initial luminous efficiency and high long-term reliability. The surface-treated phosphor of the disclosure and a wavelength conversion member and a light emission device which include the same surface-treated phosphor have high initial luminous efficiency and high long-term reliability.

### BRIEF DESCRIPTION OF DRAWINGS

[FIG. 1] FIG. 1 is a diagram illustrating an example of a method of manufacturing a surface-treated phosphor according to the embodiment of the disclosure, showing a mixing step A, heating steps B and C, and a cleaning step.
[FIG. 2] FIG. 2 is a diagram illustrating an example of a scanning electron micrograph of surface-treated phosphor powder according to an embodiment of the disclosure.
[FIG. 3] FIG. 3 is a schematic diagram illustrating a surface-treated phosphor and a wavelength conversion member according to the embodiment of the disclosure.
[FIG. 4] FIG. 4 is a perspective view of a semiconductor light emission device according to the embodiment of the disclosure.
[FIG. 5A] FIG. 5A is a cross-sectional view taken along a line 5A-5A in FIG. 4.
[FIG. 5B] FIG. 5B is a cross-sectional view taken along a line 5B-5B in FIG. 4.
[FIG. 6] FIG. 6 is a view for explaining a method of forming a sealing member in the semiconductor light emission device illustrated in FIG. 4.

### DESCRIPTION OF EMBODIMENT

Prior to an embodiment of the disclosure, a description is given of problems in relevant methods to manufacture a surface-treated phosphor.

At forming the surface treatment layer by the method of Patent Literature 1, the alkaline-earth silicate phosphor comes into contact with a surface treatment solution. The surface of the alkaline-earth silicate phosphor reacts with water to form a hydroxide before the surface treatment layer is formed. This reduces the initial luminous efficiency of the surface-treated phosphor obtained by the manufacturing method of PATENT LITERATURE 1.

With the method of Patent Literature 1, even when the surface treatment layer is formed, water derived from the surface treatment solution remains between the surface of the alkaline-earth silicate phosphor and the surface treatment layer. The remaining water gradually deteriorates the surface of the alkaline-earth silicate phosphor over a long period of time. This also reduces the luminous efficiency gradually, that is, degrades the long-term reliability.

In the surface-treated phosphor obtained by the method of Patent Literature 1, the remaining water could deteriorate the surface treatment layer.

Hereinafter, a description is given of the method of manufacturing a surface-treated phosphor according to the embodiment of the disclosure, the surface-treated phosphor obtained by the same method, and a wavelength conversion member and a light emission device including the same in detail.

### [Method of Manufacturing Surface-treated Phosphor]

A method of manufacturing a surface-treated phosphor according to the embodiment is a method of manufacturing a surface-treated phosphor including: an alkaline-earth silicate phosphor composed of a silicate of alkaline-earth metal; and a surface treatment layer covering the surface of the alkaline-earth silicate phosphor. The method of manufacturing a surface-treated phosphor according to the embodiment includes a surface treatment step below.

### (Surface Treatment Step)

In the surface treatment step, the alkaline-earth silicate phosphor and a molten or pyrolyzed surface treatment substance are brought into contact with each other to form a surface treatment layer on the surface of the alkaline-earth silicate phosphor. The surface treatment substance is at least one selected from a group consisting of a sulfate, a phosphate, a carbonate, a borate, a boric acid, a titanate, and a fluoride. At first, the alkaline-earth silicate phosphor and surface treatment substance used in the surface treatment step are described.

### <Alkaline-earth Silicate Phosphor>

The alkaline-earth silicate phosphor used in the embodiment contains a silicate of alkaline-earth metal. The alkaline-earth silicate phosphor contains a silicate of alkaline-earth metal as a crystalline matrix of the phosphor and a substance other than the silicate of alkaline-earth metal, such as an activator agent.

In the silicate of alkaline-earth metal, the alkaline-earth metal is at least one selected from a group consisting of strontium, barium, and calcium, for example.

In the silicate of alkaline-earth metal, specifically, the crystalline structure of the matrix is the substantially same as the crystalline structure of M₃SiO₅ of M₂SiO₄, for example. Herein, M is at least a kind of alkaline-earth metal selected from a group consisting of Sr, Ba, and Ca, for example. The structure substantially same as the crystalline structure of M₃SiO₅ of M₂SiO₄ means that X-ray diffraction measurement of the silicate of alkaline-earth metal results in an X-ray diffraction pattern similar to M₃SiO₅ of M₂SiO₄.

The activator agent contained in the alkaline-earth silicate phosphor is at least one element selected from a group consisting of Fe, Mn, Cr, Bi, Ce, Pr, Nd, Sm, Eu, Tb, Dy, Ho, Er, Tm, and Yb, for example.

The alkaline-earth silicate phosphor may contain a metal element such as Zn, Ga, Al, Y, Gd, or Tb, a halogen element such as F, Cl, or Br, sulfur (S), or phosphorous (P), for example, if necessary. The alkaline-earth silicate phosphor may contain one or two or more of these elements.

Examples of the alkaline-earth silicate phosphor include an orange phosphor having a composition expressed by general formula (1), an orange phosphor having a composition expressed by general formula (2), a green or yellow phosphor having a composition expressed by general formula (3), and a green or yellow phosphor having a composition expressed by general formula (4).

(Srₗ₋ₓMₓ)_{y}SiO₅:Eu²⁺ ... (1)

In formula (1), M is at least a kind of metal selected from a group consisting of Ba and Ca. In formula (1), 0 ≤ x < 1.0, and 2.6 ≤ y ≤ 3.3.

(Srₗ₋ₓMₓ)_{y}SiO₅:Eu²⁺D ... (2)

In formula (2), M is at least a kind of metal selected from a group consisting of Ba and Ca. D is at least a halogen anion selected from a group consisting of F, Cl, and Br. In formula (2), 0 ≤ x < 1.0, and 2.6 ≤ y ≤ 3.3.

(Srₗ₋ₓMₓ)_{y}SiO₄:Eu²⁺ ... (3)

In formula (3), M is at least a kind of metal selected from a group consisting of Ba and Ca. In formula (3), 0 ≤ x ≤ 1.0, and 1.8 ≤ y ≤ 2.2.

(Srₗ₋ₓMₓ)_{y}SiO₄:Eu²⁺D ... (4)

In formula (4), M is at least a kind of metal selected from a group consisting of Ba and Ca. D is a halogen anion selected from a group consisting of F, Cl, and Br. In formula (4), 0 ≤ x < 1.0, and 1.8 ≤ y ≤ 2.2.

The alkaline-earth silicate phosphor normally has a diffractive index of 1.8 to 1.9.

Externally, the alkaline-earth silicate phosphor generally takes a granular form. The average particle diameter of the alkaline-earth silicate phosphor is not less than 1 µm, preferably not less than 5 µm, and more preferably not less than 8 µm and not more than 50 µm. Herein, the average particle diameter refers to median diameter (D₅₀). The average particle diameter is obtained using a laser diffraction scattering method with a laser diffraction-type particle size distribution measurement apparatus. The average particle diameter can be also calculated by microscopic observation with an SEM or the like.

When the alkaline-earth silicate phosphor has a large average particle diameter, the low defect density in the alkaline-earth silicate phosphor particles reduces the energy loss at light emission, increasing the luminous efficiency. When the average particle diameter of the alkaline-earth silicate phosphor is less than 1 µm, the alkaline-earth silicate phosphor is more likely to have low luminance. Moreover, the alkaline-earth silicate phosphor is subject to aggregation, creating difficulties in uniform coating. When the alkaline-earth silicate phosphor has an average particle diameter within the aforementioned range, therefore, the energy loss at light emission is reduced, the luminous efficiency is increased, and uniform coating is easily attained.

When the average particle diameter of the alkaline-earth silicate phosphor is too large, the resultant surface-treated phosphor disperses less within a translucent medium, adversely affecting the properties of the wavelength conversion member and light emission device. When the surface-treated phosphor is strictly required to have dispersibility, therefore, the practical upper limit of the average particle diameter of the alkaline-earth silicate phosphor is set to 50 µm as described above.

<Surface Treatment Substance>

The surface treatment substance used in the embodiment is a raw material constituting a surface treatment layer that covers the surface of the alkaline-earth silicate phosphor.

The surface treatment substance used in the embodiment is at least one selected from a group consisting of a sulfate, a phosphate, a carbonate, a borate, a boric acid, a titanate, and a fluoride.

As the sulfate, ammonium sulfate (melting point: 357°C), ammonium hydrogen sulfate (melting point: 147°C), triammonium hydrogen sulfate (melting point: 186°C), and sodium hydrogen sulfate (decomposed at 315°C) are used, for example. As the sulfate, potassium sulfate (melting point: 1067°C) and aluminum sulfate (decomposed at 770°C) are also used. Among these sulfates, ammonium sulfate and ammonium hydrogen sulfate are preferred because ammonium sulfate and ammonium hydrogen sulfate have comparatively low melting points and are easily molten.

As the phosphate, ammonium phosphate (decomposed at 155°C), ammonium hydrogen phosphate (melting point: 190°C), ammonium dihydrogen phosphate (melting point: 190°C), diammonium hydrogen phosphate (decomposed at 100°C), and potassium dihydrogen phosphate (melting point: 253°C) are used, for example. Among these substances, ammonium phosphate and ammonium hydrogen phosphate are preferred because ammonium phosphate and ammonium hydrogen phosphate have comparatively low melting points and are easily molten.

As the carbonate, ammonium carbonate (which has a melting point of 58°C and decomposes at the melting point) and ammonium hydrogen carbonate (which sublimes at a melting point of 106°C and decomposes at 58°C) are used, for example. As the carbonate, sodium carbonate (the monohydrate has a melting point of 100°C, and the decahydrate has a melting point of 34°C), sodium hydrogen carbonate (which has a melting point of 50°C and decomposes at the melting point), and potassium hydrogen carbonate (which has a melting point of 100 to 200°C and decomposes at the melting point) are also used.

As described later, the molten state and pyrolyzed state can be selected as a mode that the carbonate comes into contact with the alkaline-earth silicate phosphor. In the case of pyrolyzing the carbonate, ammonium carbonate and ammonium hydrogen carbonate are preferably used among the above-described carbonates. Ammonium carbonate and ammonium hydrogen carbonate are gasified in the process of pyrolysis, and no residue remains. Accordingly, the cleaning step subsequent to the surface treatment step is unnecessary.

As the borate, sodium metaborate (NaBO₂) and sodium tetraborate (Na₂B₄O₇) are used, for example.

In this embodiment, a boric acid as well as a borate can be used as the surface treatment substance. As the titanate, titanium alkoxide and titanium complex are used, for example. As the fluoride, ammonium fluoride (NH₄F) (which decomposes at 100°C or lower), ammonium bifluoride (NH₄HF₂) (melting point: 770°C), sodium fluoride (NaF) (melting point: 993°C), and potassium fluoride (KF) (melting point: 860°C) are used, for example.

These surface treatment substances melt to generate anions. On the other hand, in the surface of the alkaline-earth silicate phosphor with which the molten surface treatment substance will come into contact, there are normally Sr(OH)₂, Ba(OH)2, Ca(OH)₂, or the like which are hydroxides of strontium, barium, calcium, and the like, respectively, through reaction with moisture in the air or the like. When the anions produced from the molten surface treatment substance and the alkaline-earth metal hydroxide in the surface of the alkaline-earth silicate phosphor come into contact and react with each other, therefore, the surface treatment layer composed of an alkaline-earth metal salt is formed on the surface of the alkaline-earth silicate phosphor. The alkaline-earth metal salt is poorly soluble in water, and the surface treatment layer is therefore resistant to water.

A description is given of the mechanism of generating the surface treatment layer when the surface treatment substance is ammonium sulfate. When ammonium sulfate melts, sulfate ions are generated. When the generated sulfate ions come into contact with Sr(OH)₂, Ba(OH)₂, Ca(OH)₂, or the like, which are alkaline-earth metal hydroxides in the surface of the alkaline-earth silicate phosphor, in the molten salt of ammonium sulfate, reactions expressed by formulae (5) to (7) are produced. This results in formation of the surface treatment layer composed of SrSO₄, BaSO₄, CaSO₄, or the like, which are poorly soluble sulfates, on the surface of the alkaline-earth silicate phosphor.

Sr(OH)₂ + SO₄²⁻ → SrSO₄ + 2OH⁻ ... (5)

Ba(OH)₂ + SO₄²⁻ → BaSO₄ + 20H⁻ ... (6)

Ca(OH)₂ + SO₄²⁻ → CaSO₄ + 20H⁻ ... (7)

The mechanism of producing the poorly soluble sulfate from the aforementioned molten sulfate is considered to be similarly applied to the phosphate, carbonate, borate, boric acid, titanate, and fluoride, which are the surface treatment substances other than the sulfate.

Specifically, when the phosphate, carbonate, borate, boric acid, titanate, and fluoride melts, phosphate ions, carbonate ions, borate ions, titanate ions, and fluoride ions are generated, respectively. When the generated phosphate ions, carbonate ions, borate ions, titanate ions, and fluoride ions come into contact with the alkaline-earth metal hydroxide in the surface of the alkaline-earth silicate phosphor, the surface treatment layer composed of a poorly soluble salt is formed.

A description is given of the case where the surface treatment substance is ammonium carbonate as an example. When the carbonate ions generated in the molten ammonium carbonate come into contact with Sr(OH)₂, Ba(OH)₂, Ca(OH)₂, or the like, which are alkaline-earth metal hydroxides in the surface of the alkaline-earth silicate phosphor, reactions expressed by the following formulae (8) to (10) are caused. These reactions result in formation of the surface treatment layer composed of SrCO₃, BaCO₃, CaCO₃, or the like, which are poorly soluble carbonates, in the surface of the alkaline-earth silicate phosphor.

Sr(OH)₂ + CO₃²⁻ → SrCO₃ + 2OH⁻ ... (8)

Ba(OH)₂ + CO₃²⁻ → BaCO₃ + 20H⁻ ... (9)

Ca(OH)₂ + CO₃²⁻ → CaCO₃ + 20H⁻ ... (10)

Among the aforementioned surface treatment substances, the carbonates melt to generate carbonate ions CO₃²⁻ while being pyrolyzed at a temperature of about 50 to 200°C to generate CO₂ gas. In the case of using a carbonate, therefore, by properly controlling the heated state of the carbonate, it is possible to select one of the states where the carbonate is molten or where the carbonate is pyrolyzed to generate CO₂ gas.

When the carbonate is pyrolyzed to generate CO₂ gas, the mechanism of forming the surface treatment layer composed of the carbonate is considered as follows. When the CO₂ gas comes into contact with the alkaline-earth silicate phosphor, the CO₂ gas is normally considered to react with a hydroxide existing in the surface of the alkaline-earth silicate phosphor to form a poorly soluble alkaline-earth carbonate. This poorly soluble alkaline-earth carbonate is considered to constitute the surface treatment layer.

In this step, contact between the alkaline-earth silicate phosphor and surface treatment substance is implemented by bringing the alkaline-earth silicate phosphor into contact with the molten or pyrolyzed surface treatment substance. Among the above-described treatment substances, the phosphate, borate, boric acid, titanate, and fluoride are normally brought into contact with the alkaline-earth silicate phosphor in a molten state.

Among the above-described surface treatment substances, the carbonate is brought into contact with the alkaline-earth silicate phosphor in a molten state or a pyrolyzed state. The selection of the molten or pyrolyzed state can be implemented by properly controlling the temperature applied to the carbonate.

In the surface treatment step, as described above, the alkaline-earth silicate phosphor is brought into contact with the molten or pyrolyzed surface treatment substance to form the surface treatment layer on the surface of the alkaline-earth silicate phosphor. The surface treatment step normally includes plural sub-steps. Hereinafter, the sub-steps are described. The surface treatment step preferably includes a mixing step and a heating step.

### <Mixing Step>

In the mixing step, the alkaline-earth silicate phosphor is mixed with the surface treatment substance in a solid state. The method of mixing the alkaline-earth silicate phosphor with the solid-state surface treatment substance is not particularly limited and can be any publicly-known method. The vessel used for mixing is a mortar, for example.

### <Heating Step>

In the heating step, the mixture obtained through the mixing step is heated so that the surface treatment substance is molten or pyrolyzed. In the heating step, the alkaline-earth silicate phosphor comes into contact with the molten or pyrolyzed surface treatment substance to form the surface treatment layer resistant to water on the surface of the alkaline-earth silicate phosphor.

In the heating step, the vessel in which the alkaline-earth silicate phosphor is brought into contact with the molten or pyrolyzed surface treatment substance is an alumina boat, for example. The heating temperature to melt or pyrolyze the surface treatment substance is lower than 400°C, preferably not lower than 140°C and lower than 400°C, and more preferably not lower than 250°C and lower than 350°C. It is preferable for the temperature of the heating process for the surface treatment substance to be lower than 400°C because the alkaline-earth silicate phosphor is less likely to deteriorate due to high temperature. The duration of the heating process to melt or pyrolyze the surface treatment substance in the heating step is not less than 0.2 hours and not more than 3 hours, preferably not less than 0.5 hours and not more than 2 hours, and more preferably not less than 0.8 hours and not more than 1.5 hours.

Through the heating step, the surface treatment layer resistant to water is formed on the surface of the alkaline-earth silicate phosphor.

The thickness of the surface treatment layer constituting the surface-treated phosphor is normally not less than 5 nm and not more than 1000 nm, more preferably not less than 10 nm and not more than 500 nm, more preferably 20 nm and not more than 500 nm, and still more preferably not less than 40 nm and not more than 200 nm.

It is preferable for the thickness of the surface treatment layer to be not less than 5 nm. When the thickness of the surface treatment layer is not less than 5 nm, the alkaline-earth silicate phosphor is covered with the surface treatment layer with a substantially uniform thickness even if particles of the alkaline-earth silicate phosphor has rough surfaces. It is preferable for the thickness of the surface treatment layer to be not more than 1000 nm. When the thickness of the surface treatment layer is not more than 1000 nm, the surface treatment layer is less likely to be cracked and is therefore prevented from being peeled off.

In the heating step, the surface-treated phosphor is formed in the vessel in which the heating step is performed. In some cases, the surface treatment substance is attached to the surface of the surface-treated phosphor in excess. To make appropriate the material and thickness of the surface treatment layer of the surface-treated phosphor, the surface-treated phosphor is cleaned to remove excess part of the surface treatment layer when needed.

The cleaning method in the cleaning step is a method that heats the surface-treated phosphor with excess surface treatment substance attached thereto to the boiling point or the decomposition temperature of the surface treatment substance or higher for decomposition and removal, for example (a decomposition and removal step). The cleaning method is also a method that cleans the surface-treated phosphor with excess surface treatment substance attached thereto by using water or an organic solvent to remove the surface treatment substance.

The organic solvent used in the cleaning step is ethanol, for example. Even when water is used as the cleaning solution in the cleaning step, the alkaline-earth silicate phosphor of the surface-treated phosphor is rarely substantially deteriorated by contact with water since the surface treatment layer formed in the surface is excellent in moisture resistance.

After the heating step, the surface-treated phosphor properly subjected to the decomposition removal step or cleaning step is properly dried, so that the surface-treated phosphor according to the embodiment is obtained. In the case of performing the cleaning step, the surface-treated phosphor in the cleaning solution, such as water or organic solvent, is subjected to suction filtration or the like, for example, to be separated and collected from the cleaning solution.

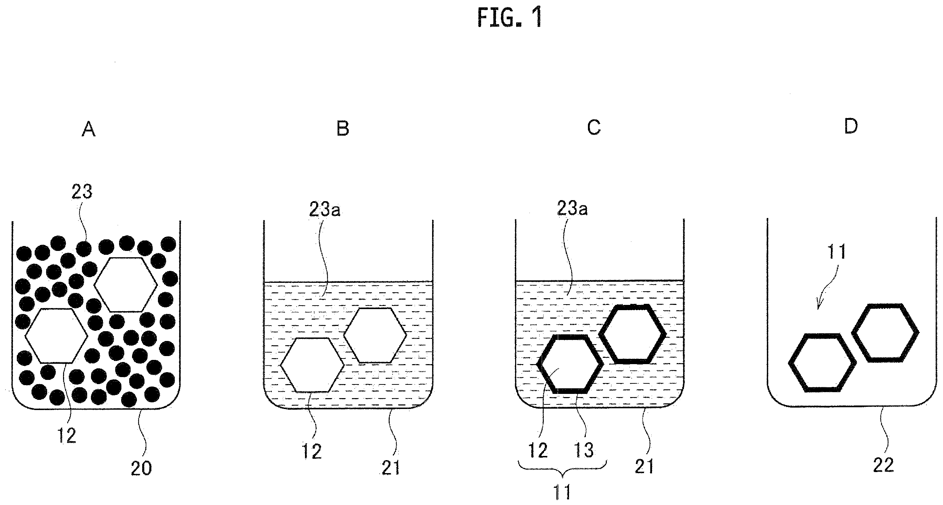

Hereinafter, a description is given of an example of the method of manufacturing a surface-treated phosphor of the embodiment with reference to the drawings. FIG. 1 is a diagram illustrating an example of the method of manufacturing a surface-treated phosphor of the embodiment. FIG. 1 illustrates mixing step A, heating steps B and C, and cleaning step D.

At first, in the mixing step A, an alkaline-earth silicate phosphor 12 and a surface treatment substance 23 in a solid state are mixed in a mixing vessel 20. Next, the powder mixture of the alkaline-earth silicate phosphor 12 and surface treatment substance 23 is transferred to a heating vessel 21. In the heating step B, when the heating vessel 21 is heated, the solid-state surface treatment substance 23 melts into a molten surface treatment substance 23a. The molten surface treatment substance 23a reacts with the surface of the alkaline-earth silicate phosphor 12 to form a surface treatment layer 13. In the heating step C, in the molten surface treatment substance 23a, a surface-treated phosphor 11 including the alkaline-earth silicate phosphor 12 and the surface treatment layer 13 covering the surface of the alkaline-earth silicate phosphor 12 is produced.

When the surface-treated phosphor 11 in the heating step C is extracted, cleaned, and properly dried, the surface-treated phosphor 11 is obtained. In the cleaning step D, the obtained surface-treated phosphor 11 is accommodated in a storage container 22, for example. FIG. 1 is a schematic diagram, and the profiles of the alkaline-earth silicate phosphor 12, surface treatment substance 23, and surface-treated phosphor 11 are not limited to those in FIG. 1.

The method of manufacturing the surface-treated phosphor according to the embodiment is a method of manufacturing a surface-treated phosphor including an alkaline-earth silicate phosphor containing a silicate of alkaline-earth metal and a surface treatment layer covering the surface of the alkaline-earth silicate phosphor. The manufacturing method includes the surface treatment step. In the surface treatment step, the alkaline-earth silicate phosphor and the molten or pyrolyzed surface treatment substance are brought into contact to form the surface treatment layer on the surface of the alkaline-earth silicate phosphor. The surface treatment substance is at least one selected from a group consisting of a sulfate, a phosphate, a carbonate, a borate, a boric acid, a titanate, and a fluoride.

With the method of manufacturing a surface-treated phosphor according to the embodiment, it is possible to manufacture a surface-treated phosphor with high initial luminous efficiency and high long-term reliability.

Specifically, with the method of manufacturing a surface-treated phosphor according to the embodiment, the alkaline-earth silicate phosphor does not come into contact with water in the process of forming the surface treatment layer. This prevents initial deterioration in the alkaline-earth silicate phosphor due to contact with water.

With the method of manufacturing a surface-treated phosphor according to the embodiment, water is less likely to remain in the interface between the alkaline-earth silicate phosphor and the surface treatment layer. This prevents deterioration in the alkaline-earth silicate phosphor over a long period of time.

With the method of manufacturing a surface-treated phosphor according to the embodiment, moreover, the alkaline-earth silicate phosphor and surface treatment substance are only mixed and heated, and it is therefore possible to produce moisture-proof coating with a simple process.

With the method of manufacturing a surface-treated phosphor according to the embodiment, it is possible to reduce waste organic solvent or water, which was generated in large quantity in the process of forming conventional moisture-proof coating. With the method of manufacturing a surface-treated phosphor according to the embodiment, therefore, it is possible to reduce the environmental impact and reduce the processing cost.

Moreover, the method of manufacturing a surface-treated phosphor according to the embodiment does not require an organic solvent or water to dissolve the surface treatment substance. The surface of the surface-treated phosphor therefore has little potential to deteriorate due to contamination by the organic solvent or water. With the method of manufacturing a surface-treated phosphor according to the embodiment, it is possible to prevent deterioration in the alkaline-earth silicate phosphor over a long period of time.

With the method of manufacturing a surface-treated phosphor according to the embodiment, the diffractive index of the surface treatment layer is set between diffractive indices of the alkaline-earth silicate phosphor and translucent medium. The surface-treated phosphor according to the embodiment therefore has a light extraction efficiency higher than those in the case where the surface treatment layer is not formed, thus providing high luminous efficiency.

### [Surface-treated Phosphor]

The surface-treated phosphor according to the embodiment is manufactured using the above-described method of manufacturing a surface-treated phosphor. The surface-treated phosphor according to the embodiment includes: an alkaline-earth silicate phosphor containing a silicate of an alkaline-earth metal; and a surface-treated layer covering the surface of the alkaline-earth silicate phosphor.

### <Alkaline-earth silicate Phosphor>

The alkaline-earth silicate phosphor constituting the surface-treated phosphor according to the embodiment is the same as one described in the above-described method of manufacturing a surface-treated phosphor. The description thereof is omitted.

### <Surface Treatment Layer>

The surface treatment layer is composed of a sulfate, a phosphate, a borate, a boric acid, a titanate, or a fluoride of at least a kind of alkaline-earth metal selected from a group consisting of Sr, Ba, and Ca. These compounds are resistant to moisture, and the surface-treated phosphor is therefore resistant to moisture.

Examples of the sulfate of an alkaline-earth metal include barium sulfate (BaSO₄, diffractive index: about 1.64) and strontium sulfate (SrSo₄, diffractive index: about 1.63). Examples of the phosphate of an alkaline-earth metal include strontium phosphate (Sr₃(PO₄)₂, diffractive index: about 1.6). Examples of the carbonate of an alkaline-earth metal include strontium carbonate (SrCO₃, diffractive index: about 1.5) and barium carbonate (BaCO₃, diffractive index: about 1.6). Examples of the borate of an alkaline-earth metal include barium metaborate (BaB₂O₄, diffractive index: about 1.6).

The aforementioned substances as the component of the surface treatment layer is water-resistant and improve the water resistance of the alkaline-earth silicate phosphor. Moreover, the diffractive index of the surface treatment layer containing the aforementioned substances is higher than the translucent medium described later and is between the diffractive indices of the phosphor and translucent medium. When the diffractive index of the surface treatment layer is between the diffractive indices of the phosphor and translucent medium, excitation light (primary light) radiated from an excitation source, such as an LED chip, is reflected less when the excitation light is incident on the surface treatment layer of the surface-treated phosphor from the translucent medium. When the diffractive index of the surface treatment layer is between the diffractive indices of the phosphor and translucent medium, light emitted from the phosphor is reflected less when the emitted light exits from the phosphor to the translucent medium. It is therefore preferred that the diffractive index of the surface treatment layer is between the diffractive indices of the phosphor and translucent medium.

The thickness of the surface treatment layer constituting the surface-treated phosphor is normally not less than 5 nm and not more than 1000 nm, preferably not less than 10 nm and not more than 500 nm, more preferably not less than 20 nm and not more than 500 nm, and still more preferably not less than 40 nm and not more than 200 nm. The reasons therefor are described in the aforementioned method of manufacturing a surface-treated phosphor, and the description thereof is omitted.

The surface-treated phosphor according to the embodiment has high initial luminous efficiency and high long-term reliability.

When the surface-treated phosphor according to the embodiment is irradiated with excitation light (primary light) from an excitation source such as an LED chip, the alkaline-earth silicate phosphor constituting a core of the surface-treated phosphor converts a part of the excitation light to longer wavelength light (secondary light). The secondary light is radiated out of the surface-treated phosphor through the surface treatment layer.

Hereinafter, the manufacturing method and properties of the surface-treated phosphor of the disclosure are specifically described below by taking phosphor samples as examples. The disclosure is not limited to the sample examples.

### (Sample #1)

At first, 5 g of powder of europium-activated barium·strontium·orthosilicate phosphor ((Ba,Sr)₂SiO₄:Eu²⁺, λₚ = 530 nm) and 10 g of ammonium hydrogen carbonate are mixed in a mortar for 5 minutes (the mixing step). The obtained powder mixture is transferred to an alumina boat and is subjected to a heating process at 300°C for one hour in the atmosphere in an electric furnace. After the heating process, a surface-treated phosphor (Sample #1) is obtained, which includes a surface treatment layer composed of barium carbonate and strontium carbonate on the surface of the (Ba,Sr)₂SiO₄:Eu²⁺ phosphor (the heating step). The surface treatment layer of the surface-treated phosphor has a thickness of about 70 nm.

### (Sample #2)

100 ml of ethanol in which 5 g of powder of the surface-treated phosphor of Sample #1 is dispersed is stirred for 20 minutes for cleaning of the surface-treated phosphor of Sample #1. After the cleaning, the surface-treated phosphor and ethanol are subjected to solid-liquid separation using filter paper. The obtained surface-treated phosphor is dried at 150°C for one hour. After the drying process, a surface-treated phosphor (Sample #2) is obtained, which includes surface treatment composed of barium carbonate and strontium carbonate on the surface of the (Ba,Sr)₂SiO₄:Eu²⁺ phosphor. The surface treatment layer of the surface-treated phosphor powder has a thickness of about 40 nm.

### (Sample #3)

In a similar manner to Sample #1, 5 g of powder of (Ba,Sr)₂SiO₄:Eu²⁺ phosphor and 10 g of ammonium carbonate are mixed in a mortar for 5 minutes (the mixing step). The obtained powder mixture is transferred to an alumina boat and is subjected to a heating process at 300°C for one hour in the atmosphere in an electric furnace. After the heating process, a surface-treated phosphor (Sample #3) is obtained, which includes a surface treatment layer composed of barium carbonate and strontium carbonate on the surface of the (Ba,Sr)₂SiO₄:Eu²⁺ phosphor (the heating step). The surface treatment layer of the surface-treated phosphor has a thickness of about 80 nm.

Sample #3 is different from Sample #1 in that the surface treatment agent was changed from ammonium hydrogen carbonate to ammonium carbonate.

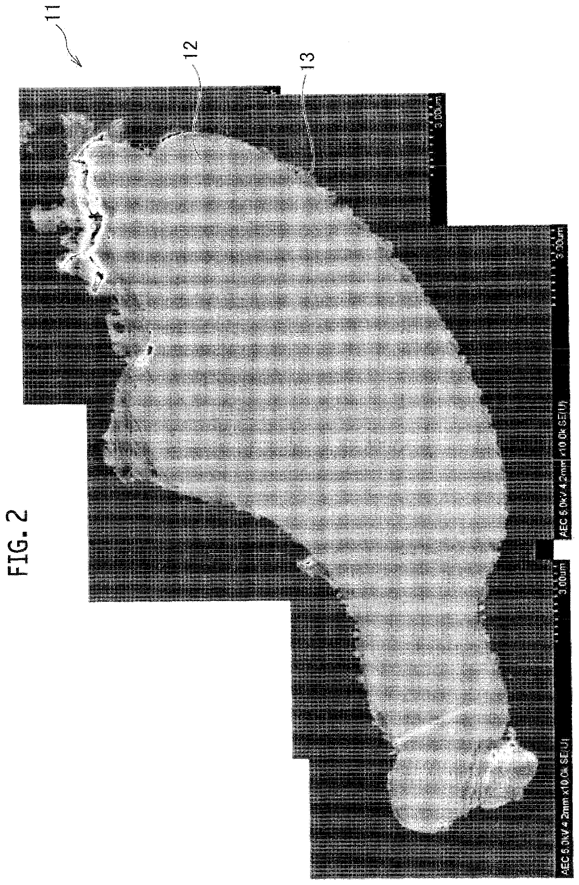

FIG. 2 illustrates an example of scanning electron micrographs of a cross section of the surface-treated phosphor of Sample #3. In the surface-treated phosphor, a surface treatment layer is formed on the surface of (Ba,Sr)₂SiO₄:Eu²⁺ phosphor particles.

### (Sample #4)

100 ml of ethanol in which 5 g of powder of the surface-treated phosphor of Sample #3 is dispersed is stirred for 20 minutes for cleaning the surface-treated phosphor of Sample #3. After the cleaning, the surface-treated phosphor and ethanol are subjected to solid-liquid separation using filter paper. The obtained surface-treated phosphor is subjected to the same cleaning process and solid-liquid separation process as described above on two further occasions. The surface-treated phosphor is subjected to the cleaning process and solid-liquid separation process three times in total. The obtained surface-treated phosphor is dried at 150°C for one hour. After the drying process, a surface-treated phosphor (Sample #4) is obtained, which includes surface treatment composed of barium carbonate and strontium carbonate on the surface of the (Ba,Sr)₂SiO₄:Eu²⁺ phosphor. The surface treatment layer of the surface-treated phosphor has a thickness of about 40 nm.

### (Sample #5)

In a similar manner to Samples #1 and #3, 5 g of powder of (Ba,Sr)₂SiO₄:Eu²⁺ phosphor and 10 g of ammonium sulfate are mixed in a mortar for 5 minutes (the mixing step). The obtained powder mixture is transferred to an alumina boat and is subjected to a heating process at 380°C for one hour in non-oxidizing atmosphere of a nitrogen/hydrogen flow in an electric furnace. After the heating process, a surface-treated phosphor is obtained, which includes a surface treatment layer composed of barium sulfate and strontium sulfate on the surface of the (Ba,Sr)₂SiO₄:Eu²⁺ phosphor (the heating step).

100 ml of water in which 5 g of powder of the obtained surface-treated phosphor is dispersed is stirred for 20 minutes for cleaning the surface-treated phosphor. After the cleaning, the surface-treated phosphor and water are subjected to solid-liquid separation using filter paper. The obtained surface-treated phosphor is subjected to the same cleaning process and solid-liquid separation process as described above on two further occasions. The surface-treated phosphor is subjected to the cleaning process and solid-liquid separation process three times in total. The obtained surface-treated phosphor is dried at 150°C for one hour. After the drying process, a surface-treated phosphor (Sample #5) is obtained, which includes surface treatment composed of barium sulfate and strontium sulfate on the surface of the (Ba,Sr)₂SiO₄:Eu²⁺ phosphor. The surface treatment layer of the surface-treated phosphor has a thickness of about 20 nm.

Sample #6 is a (Ba,Sr)₂SiO₄:Eu²⁺ phosphor (not subjected to the surface treatment). Sample #7 is a phosphor obtained by heating 5 g of powder of (Ba,Sr)₂SiO₄:Eu²⁺ phosphor in an alumina boat, at 300°C for one hour in the atmosphere in an electric furnace.

Table 1 shows the production conditions, the thickness of the surface treatment layer, the initial luminous efficiency, and the moisture resistance of Samples #1 to #7 described above.

**(Table 1)**

| | SURFACE TREATMENT STEP | | | CLEANING STEP | SURFACE-TREATED PHOSPHOR | | | NOTE |
|---|---|---|---|---|---|---|---|---|
| | SURFACE TREATMENT SUBSTANCE | HEATING TEMPERATURE (°C) | HEATING TIME (H) | CLEANING AGENT | THICKNESS OF SURFACE TREATMENT LAYER (nm) | RELATIVE VALUE OF INITIAL LUMINOUS EFFICIENCY (-) | RELATIVE VALUE OF LUMINOUS EFFICIENCY AFTER MOISTURE RESISTANCE TEST (-) | |
| #1 | Ammonium Hydrogen Carbonate | 300 | 1 | No Cleaning | 70 | 103 | 92 | |
| #2 | Ammonium Hydrogen Carbonate | 300 | 1 | Ethanol | 40 | 104 | 94 | |
| #3 | Ammonium Carbonate | 300 | 1 | No Cleaning | 80 | 101 | 93 | |
| #4 | Ammonium Carbonate | 300 | 1 | Ethanol | 40 | 104 | 95 | |
| #5 | Ammonium Sulfate | 300 | 1 | Water | 20 | 101 | 89 | |
| #6 | - | - | - | No Cleaning | - | 100 | - | No Surface Treatment |
| #7 | - | 300 | 1 | No Cleaning | - | 100 | 71 | No Surface Treatment |

### (Initial Luminous Efficiency)

Generally, the luminous efficiency (Im/W) of a phosphor can be measured using a spectrofluorometer (product name: QE-1100, half moon-type integrating sphere, made by OTSUKA ELECTRONICS Co., LTD.). The measurement conditions are as follows: the excitation wavelength is 450 nm; the measurement wavelength range is not less than 460 and not more than 800 nm; and the number of scans is 30. The initial luminous efficiency of Samples #1 to #5 is expressed as relative values with the luminous efficiency (Im/W) of Sample #6 being 100.

Table 1 shows that the initial luminous efficiencies of Samples #1 to #5, each including the surface treatment layer, are 1 to 4% higher than Sample #6, which is not subjected to surface treatment.

### (Moisture Resistance)

In evaluation of the moisture resistance, the luminous efficiency is measured after Samples #1 to #5 and #7 are subjected to hygroscopic treatment shown below. In the hygroscopic treatment, at first, 1 L of water in which 1 g of powder of each of Samples #1 to #5 and #7 is dispersed is stirred for 20 minutes. Next, the dispersion solution is filtrated, and the residue is dried at 150°C for one hour, thus preparing samples for moisture resistance tests.

The initial luminous efficiency of Samples #1 to #5 for moisture resistance tests is expressed as relative values with the luminous efficiency (Im/W) of Sample #6 (not subjected to hygroscopic treatment) being 100.

Table 1 shows that the relative luminous efficiencies of Samples #1 to #5, each including the surface treatment layer, are reduced by 8 to 11 % from the respective initial luminous efficiencies. On the other hand, the relative luminous efficiency of Sample #7, not including the surface treatment layer, is reduced by 29% from the initial luminous efficiency.

From the aforementioned results, Samples #1 to #5, each including the surface treatment layer, are more excellent in initial luminous efficiency and moisture resistance than Sample #7, which is not subjected to the surface treatment.

The disclosure has been described by reference to the samples produced experimentally. The disclosure is not limited to those descriptions, and it will be apparent to those skilled in the art that various modifications and improvements can be made.

Light emission of the surface-treated phosphor requires an excitation source such as an LED chip. A description is given of a wavelength conversion member including the surface-treated phosphor and a light emission device composed of the wavelength conversion member and an excitation source.

### [Wavelength Conversion Member]

A wavelength conversion member according to the embodiment includes a translucent medium and a surface-treated phosphor dispersed in the translucent medium. In the wavelength conversion member, the surface-treated phosphor is the surface-treated phosphor according to the aforementioned embodiment. The translucent medium has a refractive index smaller than the surface treatment layer of the surface-treated phosphor.

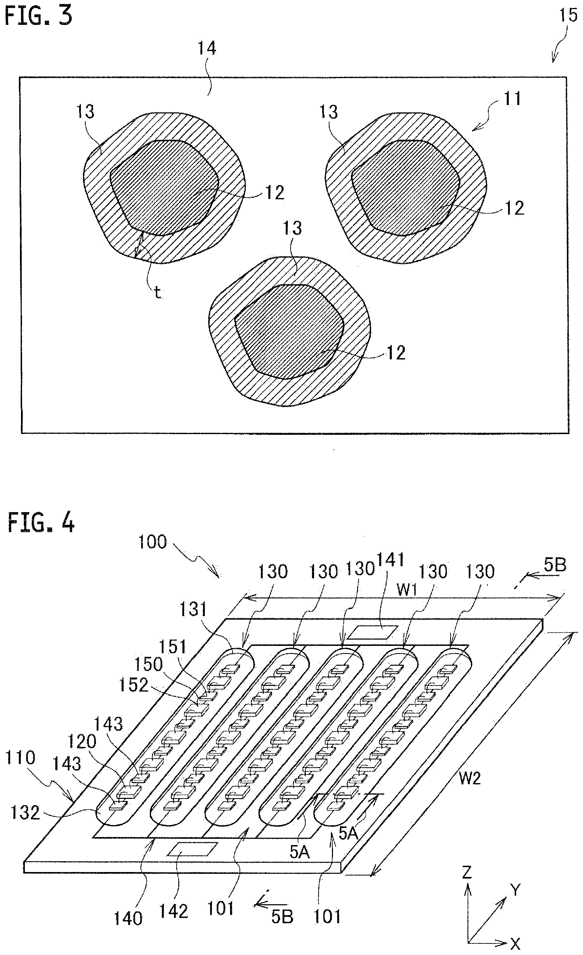

Hereinafter, a description is given of the specific configuration of the wavelength conversion member of the embodiment with reference to the drawing. FIG. 3 is a schematic view illustrating the surface-treated phosphor 11 and a wavelength conversion member 15 according to the embodiment of the disclosure.

In the wavelength conversion member 15, the surface-treated phosphor 11 is dispersed in a translucent medium 14. The surface-treated phosphor 11 includes the alkaline-earth silicate phosphor 12 and the surface treatment layer 13 covering the surface of the alkaline-earth silicate phosphor 12. In FIG. 3, reference symbol t indicates the thickness of the surface treatment layer 13.

### (Surface-treated Phosphor)

The surface-treated phosphor 11 is the same as the surface-treated phosphor according to the aforementioned embodiment, and the description thereof is omitted.

### (Translucent Medium)

The translucent medium 14 has translucency. In the translucent medium 14, the surface-treated phosphor 11 is dispersed. The translucent medium 14 is normally a translucent medium having a refractive index smaller than the refractive index of the surface treatment layer 13 of the surface-treated phosphor 11. In the case where the refractive index of the translucent medium is set smaller than that of the surface treatment layer 13 of the surface-treated phosphor 11, excitation light (primary light), which is radiated from the excitation source, such as an LED chip, is reflected less when the excitation light is incident on the surface treatment layer 13 of the surface-treated phosphor 11. Moreover, when light is emitted out of the surface-treated phosphor 11 to the translucent medium 14, the emitted light is reflected less. It is therefore preferable for the refractive index of the translucent medium to be set smaller than that of the surface treatment layer 13 of the surface-treated phosphor 11.

The translucent medium 14 is a silicate compound including a siloxane bond, glass, acrylic resin, an organic-inorganic hybrid material formed by mixing and combining organic and inorganic components at nanometer level or molecular level, or the like. Among such translucent media, the silicate compound including a siloxane bond and glass are excellent in resistance to heat and light and are particularly excellent in durability to short-wavelength light, including blue to ultraviolet light. These materials are less likely to deteriorate even when the excitation light (primary light) radiated from the excitation source, such as an LED chip, has a range of wavelength of blue to ultraviolet light.

Examples of the silicate compound are silicone resin, hydrolytic condensation products of organosiloxane, condensation products of organosiloxane, and composite resin cross-linked by a publicly-known polymerization method. The publicly-known polymerization method is addition polymerization such as hydrosilylation, radical polymerization, or the like.

The method of dispersing the surface-treated phosphor 11 in the translucent medium 14 is a method that uniformly disperses the surface-treated phosphor 11 in the translucent medium 14 in a fluidized state and then hardens the fluidized translucent medium, for example.

The wavelength conversion member 15 has a structure in which the surface-treated phosphor 11 is dispersed in the translucent medium 14. When excitation light (primary light) from an excitation source is incident on the wavelength conversion member 15, a part of the excitation light is converted to longer wavelength light (secondary light). The secondary light is radiated out of the wavelength conversion member 15 through the translucent medium 14.

The wavelength conversion member 15 according to the embodiment has high initial luminous efficiency and high long-term reliability.

### <Light Emission Device>

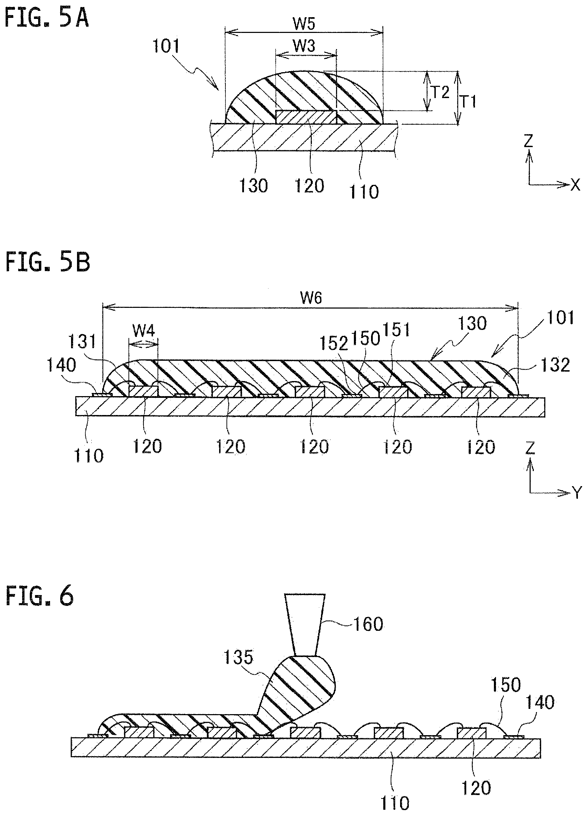

A description is given of a semiconductor light emission device 100 as an example of the light emission device of the embodiment with reference to FIGS. 4 to 6. FIG. 4 is a perspective view of the semiconductor light emission device 100. FIG. 5A is a cross-sectional view along a line 5A-5A in FIG. 4, and FIG. 5B is a cross-sectional view along a line 5B-5B in FIG. 4. FIG. 6 is a view for explaining a method of forming a sealing member in the semiconductor light emission device 100.

As illustrated in FIG. 4, the semiconductor light emission device 100 is a light emission device including plural LEDs 120 as excitation sources and a surface-treated phosphor which converts a part of light radiated from the excitation sources to longer-wavelength light and radiates the same. The semiconductor light emission device 100 further includes a substrate 110 and plural sealing members 130 including the surface-treated phosphor. The substrate 110 has a two-layer structure composed of an insulating layer made of ceramic, thermally conductive resin, or the like and a metal layer made of an aluminum plate or the like. The substrate 110 has a square-plate profile as a whole. The substrate 110 has a width W1 of 12 to 30 mm in the short-side direction (in the X-axis direction) and a width W2 of 12 to 30 mm in the longitudinal direction (in the Y-axis direction).

As illustrated in FIGS. 5A and 5B, each LED 120 has a rectangular profile in a plan view as a whole. Each LED 120 is a GaN-based LED having a peak wavelength of 440 to 500 nm, for example. Each LED 120 has a width W3 of 0.3 to 1.0 mm in the short-side direction (in the X-axis direction), a width W4 of 0.3 to 1.0 mm in the longitudinal direction (in the Y-axis direction), and a thickness (width in the Z-axis direction) of 0.08 to 0.30 mm.

In the arrangement of the plural LEDs 120, the longitudinal direction (the Y-axis direction) of the substrate 110 corresponds to the direction of device rows of the LEDs 120. The plural LEDs 120 arranged in line in the longitudinal direction of the substrate 110 constitute each device row. The plural device rows are arranged side by side in the short-side direction (the X-axis direction) of the substrate 110. Specifically, in 25 LEDs 120, five device rows each composed of five LEDs are arranged side by side, for example. When the LEDs 120 are arranged in line, the sealing members 130, sealing the LEDs 120, can be formed in a linear manner.

As illustrated in FIG. 5B, the device rows are individually sealed by the respective long sealing members 130. One of the device rows and one of the sealing members sealing the same device row constitute each light emitting section 101. The semiconductor light emission device 100 includes five light emitting sections 101.

The sealing members 130 are made of a translucent resin material containing a phosphor. The resin material can be silicone resin, fluorine resin, silicone epoxy hybrid resin, urea resin, or the like, for example. The phosphor converts a part of light radiated from the LEDs 120 to longer wavelength light and radiates the same. The sealing members 130 containing the phosphor serve as the wavelength conversion member. Herein, the phosphor can be the surface-treated phosphor of the embodiment. In addition to the surface-treated phosphor of the embodiment, the phosphor can be an oxide-based phosphor such as an oxide and an acyl halide activated by at least any one of Eu²⁺, Ce³⁺, Tb³⁺, and Mn²⁺. In addition to the surface-treated phosphor of the embodiment, the phosphor can be a nitride-based phosphor such as a nitride and an oxynitride activated by at least any one of Eu²⁺, Ce³⁺, Tb³⁺, and Mn²⁺ or a sulfide-based phosphor such as a sulfide or an oxysulfide.

Concrete examples of the phosphor used in the surface-treated phosphor of the embodiment are shown below. Examples of blue phosphors include BaMgAl₁₀O₁₇:Eu²⁺, CaMgSi₂O₆:Eu²⁺, Ba₃MgSi₂O₈: Eu²⁺, and Sr10(PO₄)₆Cl₂:Eu²⁺. Examples of green blue or blue green phosphors include Sr₄Si₃O₈Cl₄:Eu²⁺, Sr₄Al₁₄O₂₄:Eu²⁺, BaAl₈O₁₃:Eu²⁺, and Ba₂SiO₄:Eu²⁺. Examples of green blue or blue green phosphors further include BaZrSi₃O₉:Eu², Ca₂YZr₂(AlO₄)₃:Ce³⁺, Ca₂YHf₂(AlO₄)₃:Ce³⁺, and Ca₂YZr₂(AlO₄)₃:Ce³⁺,Tb³⁺. Examples of green phosphors include (Ba,Sr)₂SiO₄:Eu²⁺, Ca₈Mg(SiO₄)₄Cl₂:Eu²⁺, and Ca₈Mg(SiO₄)₄Cl₂:Eu²⁺,Mn²⁺. Examples of green phosphors further include BaMgAl₁₀O₁₇:Eu²⁺,Mn²⁺, CeMgAl₁₁O₁₉:Mn²⁺, Y₃Al₂(AlO₄)₃:Ce³⁺, and Lu₃Al₂(AlO₄)₃:Ce3+. Examples of green phosphors still further include Y₃Ga₂(AlO₄)₃:Ce³⁺, Ca₃Sc₂Si₃O₁₂:Ce³⁺, CaSc₂O₄:Ce3+, β-Si₃N₄:Eu2+, and SrSi₂O₂N₂:Eu2+. Examples of green phosphors still further include Ba₃Si₆O₁₂N₂:Eu²⁺, Sr₃Si₁₃Al₃O₂N₂₁:Eu²⁺, YTbSi₄N₆C:Ce³⁺, and SrGa₂S₄:Eu²⁺. Examples of green phosphors still further include Ca₂LaZr₂(AlO₄)₃:Ce³⁺, Ca₂TbZr₂(AlO₄)₃:Ce³⁻, and Ca₂TbZr₂(AlO₄)₃:Ce³⁺Pr³⁺. Examples of green phosphors still further include Zn₂SiO₄:Mn²⁺ and MgGa₂O₄:Mn²⁺. Examples of green phosphors still further include LaPO₄:Ce³⁺,Tb³⁺, Y₂SiO₄:Ce³⁺, CeMgAl₁₁O₁₉:Tb³⁺, and GdMgB₅O₁₀:Ce³⁺,Tb³⁺. Examples of yellow or orange phosphor include (Sr,Ba)₂SiO₄:Eu²⁺, (YGd)₃Al₅O₁₂:Ce³⁺, and α-Ca-SiAlON:Eu²⁺. Examples of yellow or orange phosphors include Y₂Si₄N₆C:Ce³⁺, La₃Si₆N₁₁:Ce³⁺, and Y₃MgAl(AlO₄)₂(SiO₄):Ce³⁺. Examples of red phosphors include Sr₂Si₅N₈:Eu²⁺, CaAlSiN₃:Eu²⁺, SrAlSi₄N₇:Eu²+, CaS:Eu²⁺, La₂O₂S:Eu³, and Y₃Mg₂(AlO₄)(SiO₄)₂:Ce³⁺ Examples of red phosphors include Y₂O₃:Eu³⁺, Y₂O₂S:Eu³⁺, Y(P,V)O₄:Eu3+, and YVO₄:Eu3+. Examples of red phosphors include 3.5MgO·0.5MgF₂·GeO₂:Mn⁴⁺, K₂SiF₆:Mn⁴⁺, and GdMgB₅O₁₀:Ce³⁺,Mn²⁺.

As illustrated in FIG. 5B, the sealing members 130 are preferably long and thin. Specifically, the sealing member 130 preferably has a width W5 of 0.8 to 3.0 mm in the short-side direction (in the X-axis direction) and a width W6 of 3.0 to 40.0 mm in the longitudinal direction (in the Y-axis direction). Preferably, the maximum thickness (width in the Z-axis direction) T1 of the sealing member 130 including the LEDs 120 is preferably 0.4 to 1.5 mm while the maximum thickness T1 not including the LEDs 120 is 0.2 to 1.3 mm. To ensure sealing reliability, the width W5 of the sealing members 130 is preferably two to seven times the width W3 of the LEDs 120.

The cross-section of each sealing member 130 in the short-side direction has a semi-elliptic profile as illustrated in FIG. 5A. Both ends 131 and 132 of the sealing member 130 in the longitudinal direction are round. Specifically, the plan view of each end 131 and 132 has a semicircular shape as illustrated in FIG. 4. The cross-sectional shape thereof in the longitudinal direction is a sector having a central angle of about 90° as illustrated in FIG. 5B. When the ends 131 and 132 of the sealing member 130 are round as described above, the ends 131 and 132 are less subject to stress concentration, and light emitted from the LEDs 120 is easily extracted out of the sealing member 130.

Each LED 120 is mounted on the substrate 110 facing up. The LEDs 120 are electrically connected to a lighting circuit (not illustrated) through a wiring pattern 140 formed on the substrate 110. The wiring pattern 140 includes a pair of power supply lands 141 and 142 and plural bonding lands 143 located at positions corresponding to the respective LEDs 120.

As illustrated in FIG. 5B, the LEDs 120 are electrically connected to the lands 143 through wires (gold wires, for example) 150, for example. An end 151 of each wire 150 is bonded to one of the LEDs 120, and the other end 152 is bonded to one of the lands 143. The wires 150 are arranged in the direction of the device rows. The wires 150 are sealed in the sealing members 130 together with the LEDs 120 and lands 143 and are less likely to deteriorate. The wires 150 are insulated by the sealing members 130. The method of mounting the LEDs 120 on the substrate 110 is not limited to face-up mounting as described above and may be flip-chip mounting.

In the LEDs 120, as illustrated in FIG. 4, five LEDs 120 located in the same device row are connected in series, and five device rows are connected in parallel. The connection of the LEDs 120 is not limited to the above-described connection, and the LEDs 120 may be connected in any fashion regardless of device rows. The lands 141 and 142 are connected to a pair of leads (not illustrated), and electric power is supplied to each LED 120 from a lighting circuit unit through the leads.

The sealing member 130 can be formed by the following procedure. On the substrate 110 on which the LEDs 120 are mounted in line, resin paste 135 is applied in the linear manner along the device rows using a dispenser 160, for example. The applied resin paste 135 is then solidified to form the sealing members 130 separately for the respective device rows.

The semiconductor light emission device of the embodiment can be widely used for illumination light sources, backlights of liquid crystal displays, light sources of display devices, and the like.

An illumination light source includes the semiconductor light emission device of the embodiment, a lighting circuit configured to supply electric power to the semiconductor light emission device, and a cap as a connector for light fixtures. The light fixtures are properly combined to constitute lighting apparatuses and systems. The light source employing the semiconductor light emission device of the embodiment has high initial luminous efficiency and high long-term reliability.

In the semiconductor light emission device 100, the LEDs are used as the excitation source. However, the excitation source is not limited to the LEDs and, in the light emission device according to the disclosure, can be properly selected from discharge devices, electron guns, solid light emitting devices, and the like.

The semiconductor light emission device 100 is an example in which the excitation source is embedded in the wavelength conversion member (the sealing members 130) including the surface-treated phosphor. In the light emission device according to the disclosure, the excitation source and wavelength conversion member may be separately arranged.

### REFERENCE SIGN LIST

11 SURFACE-TREATED PHOSPHOR
12 ALKALINE-EARTH SILICATE PHOSPHOR (EUROPIUM-ACTIVATED BARIUM·STRONTIUM·ORTHOSILICATE PHOSPHOR PARTICLES)
13 SURFACE TREATMENT LAYER
14 TRANSLUCENT MEDIUM
15 WAVELENGTH CONVERSION MEMBER

## Claims

1. A method of manufacturing a surface-treated phosphor in which the surface of an alkaline-earth silicate phosphor containing a silicate of alkaline-earth metal is covered with a surface treatment layer, the method comprising:
surface treatment which brings the alkaline-earth silicate phosphor into contact with the surface treatment substance molten or pyrolyzed to form the surface treatment layer on the surface of the alkaline-earth silicate phosphor wherein
the surface treatment substance is at least one selected from a group consisting of a sulfate, a phosphate, a carbonate, a borate, a boric acid, a titanate, and a fluoride.

2. The method of manufacturing a surface-treated phosphor according to claim 1, wherein
the surface treatment includes:
mixing the alkaline-earth silicate phosphor with the surface treatment substance in a solid state; and
heating a mixture obtained by the mixing to melt or pyrolyze the surface treatment substance.

3. The method of manufacturing a surface-treated phosphor according to claim 1 or 2, wherein
the surface treatment layer has a thickness of not less than 5 nm and not more than 1000 nm.

4. The method of manufacturing a surface-treated phosphor according to any one of claims 1 to 3, wherein the silicate of the alkaline-earth metal is a silicate of at least a kind of alkaline-earth metal selected from strontium, barium, and calcium.

5. A surface-treated phosphor manufactured by using the method of manufacturing a surface-treated phosphor according to any one of claims 1 to 4.

6. A wavelength conversion member, comprising:
a translucent medium; and
the surface-treated phosphor according to claim 5 dispersed in the translucent medium, wherein
the translucent medium has a refractive index smaller than the surface treatment layer.

7. A light emission device, comprising:
an excitation source; and
the surface-treated phosphor according to claim 5 which converts a part of light radiated from the excitation source to light of longer wavelength and radiates the light of longer wavelength.

8. A light emission device, comprising:
an excitation source; and
the wavelength conversion member according to claim 6 which converts a part of light radiated from the excitation source to light of longer wavelength and radiates the light of longer wavelength.
